# EUROPEAN PATENT APPLICATION

(11) **EP 4 672 336 A1**
(43) Date of publication of application: **31.12.2025**
(21) Application number: 23924148.2
(22) Date of filing: 27.09.2023
(51) Int. Cl.: H01L 25/07, H01L 25/18

(54) **SEMICONDUCTOR MODULE**

(30) Priority: 24.02.2023 JP 2023027015
(71) Applicant: Minebea Power Semiconductor Device Inc., Ibaraki 319-1221 (JP)
(72) Inventor: KONNO, Akitoyo, Hitachi-shi, Ibaraki 319-1221 (JP); SAITO, Katsuaki, Hitachi-shi, Ibaraki 319-1221 (JP); MIMA, Akira, Tokyo 100-8280 (JP)
(74) Representative: MERH-IP Matias Erny Reichl Hoffmann Patentanwälte PartG mbB
(86) International application number: PCT/JP2023/035229
(87) International publication number: WO 2024/176504

(57) **Abstract**

A semiconductor module having a wide region where a circuit board can be installed is implemented. A first circuit board installation region 7 in which a circuit board for controlling a plurality of semiconductor chips using auxiliary terminals 6 can be installed and a second circuit board installation region 8 in which a circuit board protruding portion of a protruding and extending portion of the circuit board can be installed are provided on an upper surface of an insulating resin case 2 of the semiconductor module 1. The second circuit board installation region 8 has a shape including at least a portion of the region between the pair of first potential terminals 3, and at least a portion of the region between the pair of second potential terminals 4, and is a first recess 12 partitioned by a first protrusion 9 provided on the upper surface of the insulating resin case 2. The upper surface of the insulating resin case 2 has a second protrusion 10 provided between each of the pair of first potential terminals 3 on the high potential side and the first protrusion 9, and a second recess 13 formed between the first protrusion 9 and the second protrusion 10.

## Description

### Technical Field

The present invention relates to a semiconductor module.

### Background Art

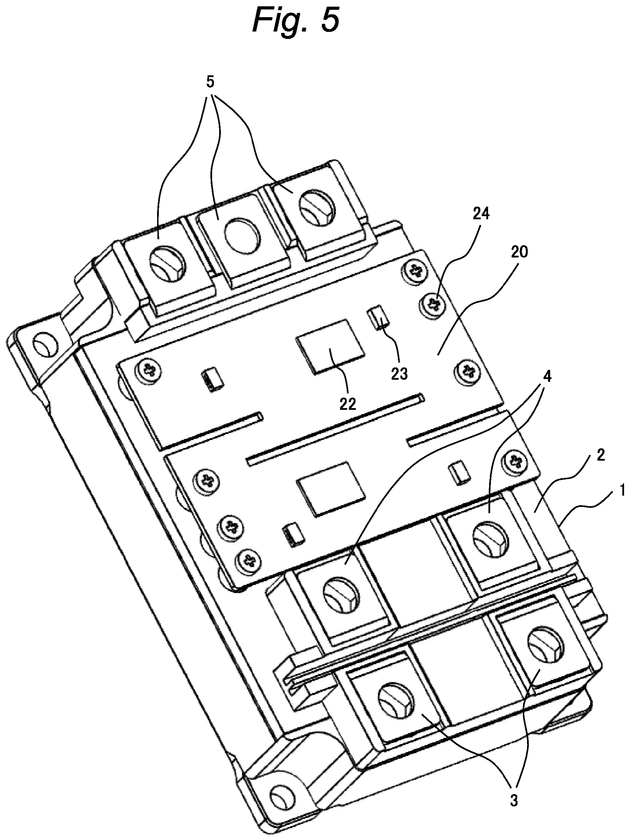

Fig. 5 is a perspective view illustrating a conventional semiconductor module in which a circuit board is installed.

A semiconductor module 1 includes a plurality of semiconductor chips (not shown), an insulating resin case 2 that accommodates the plurality of semiconductor chips in the inside thereof, and a plurality of external terminals led out to an upper surface of the insulating resin case 2, and has a pair of first potential terminals 3, a pair of second potential terminals 4, an AC terminal 5, and an auxiliary terminal not shown as the plurality of external terminals.

A circuit board 20 for controlling the plurality of semiconductor chips accommodated in the inside thereof is installed in the semiconductor module 1. The circuit board 20 has a semiconductor chip for a drive circuit 22 and a connector 23, and is fixed to the upper surface of the insulating resin case 2 of the semiconductor module 1 by screws 24.

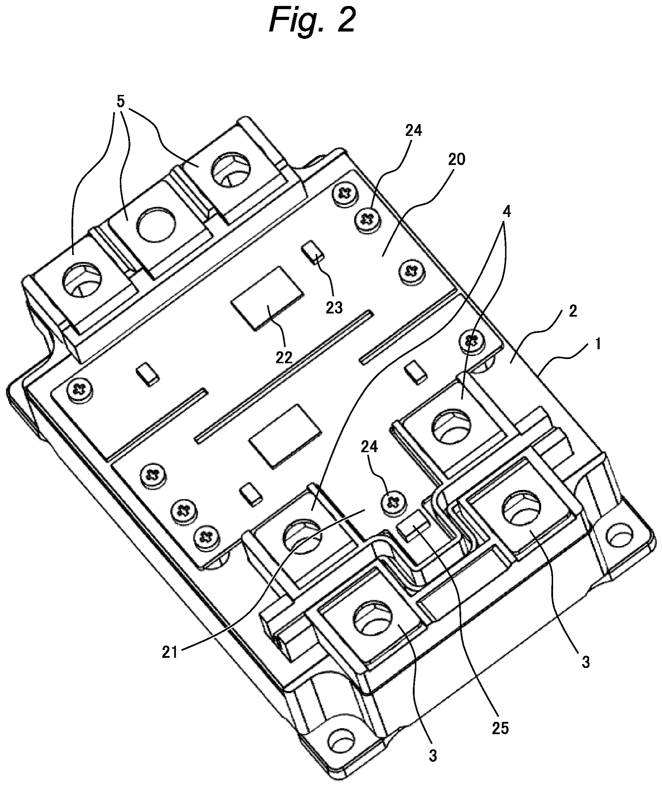

Such a semiconductor module is also described, for example, in Fig. 2 of Patent Literature 1.

### Citation List

### Patent Literature

Patent Literature 1: Japanese Patent Application Publication No. 2017-92789

### Summary of Invention

### Technical Problem

However, in the conventional semiconductor module 1, the circuit board 20 is generally disposed between the pair of second potential terminals 4 and the AC terminal 5, and there is a problem that the area where the circuit board 20 can be installed is narrow.

An object of the present invention is to achieve a semiconductor module having a wide region where a circuit board can be installed.

### Solution to Problem

In order to solve the above problem, a semiconductor module of the present invention includes a plurality of semiconductor chips, an insulating resin case that accommodates the plurality of semiconductor chips in the inside thereof, and a plurality of external terminals led out to an upper surface of the insulating resin case. The semiconductor module is characterized in that the plurality of external terminals have a pair of first potential terminals, a pair of second potential terminals having a lower potential than that of the pair of first potential terminals, at least one AC terminal, and a plurality of auxiliary terminals used for controlling the plurality of semiconductor chips; the upper surface of the insulating resin case has a first circuit board installation region where a circuit board for controlling the plurality of semiconductor chips using the plurality of auxiliary terminals can be installed, and a second circuit board installation region where a circuit board protruding portion of a protruding and extending portion of the circuit board can be installed; the second circuit board installation region has a shape including at least a portion of the region between the pair of first potential terminals and at least a portion of the region between the pair of second potential terminals, and is a first recess partitioned by a first protrusion provided on the upper surface of the insulating resin case; and the upper surface of the insulating resin case has a second protrusion provided between each of the pair of first potential terminals and the first protrusion, and a second recess formed between the first protrusion and the second protrusion. Advantageous Effects of Invention

According to the present invention, a semiconductor module having a wide region where a circuit board can be installed can be realized.

Other configurations and effects of the present invention will be described in the Examples.

### Brief Description of Drawings

[Fig. 1]

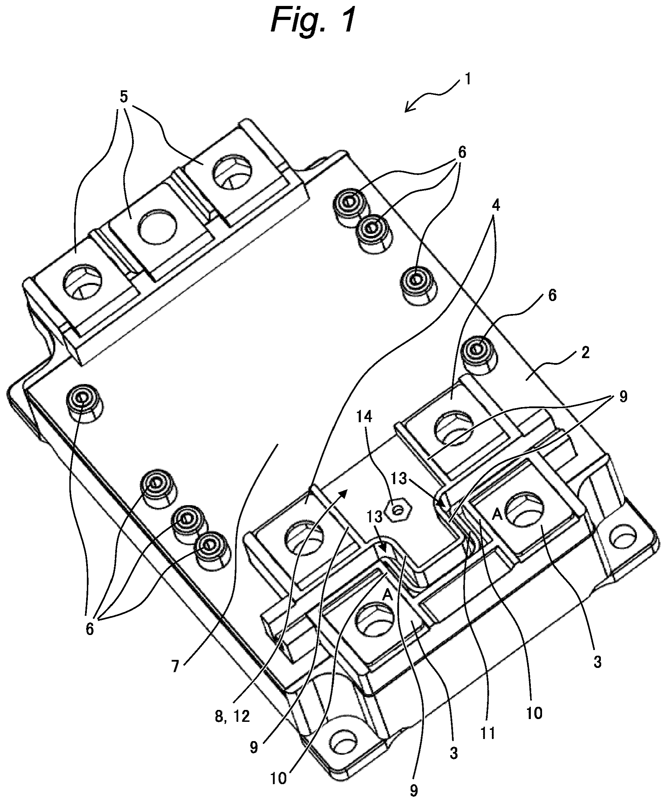

   Fig. 1 is a perspective view of the semiconductor module of Example 1.
[Fig. 2]
   Fig. 2 is a perspective view illustrating the semiconductor module of Example including a circuit board installed therein.
[Fig. 3]

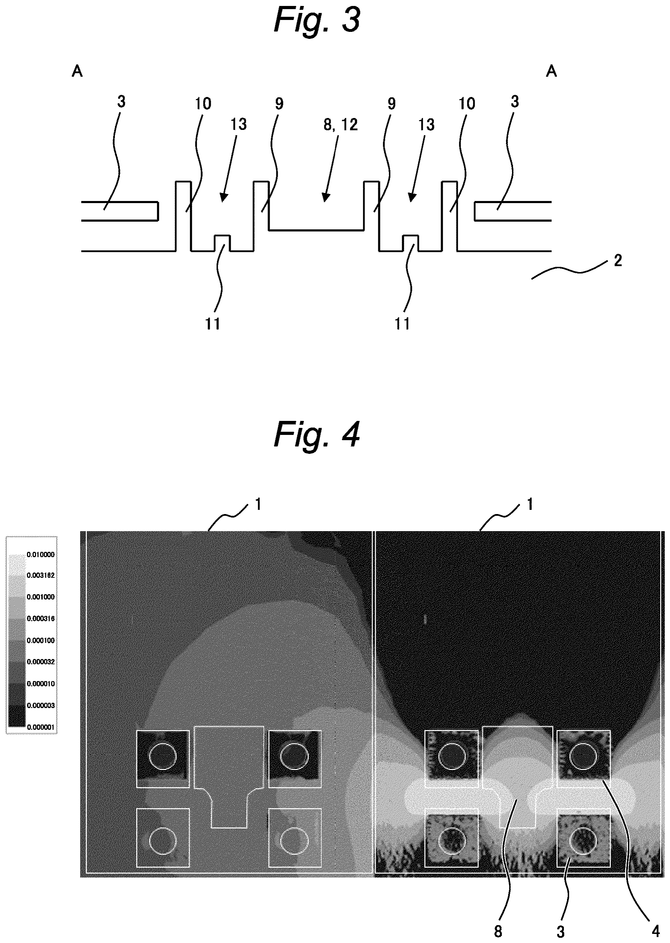

   Fig. 3 is a cross-sectional view taken along line A-A in Fig. 1.
[Fig. 4]
   Fig. 4 is a view illustrating the results of simulation of the magnetic flux density distribution generated when a short circuit occurs in one semiconductor module in a state where two semiconductor modules of the Example are arranged in parallel.
[Fig. 5]
   Fig. 5 is a perspective view illustrating a state where a circuit board is installed on a conventional semiconductor module.

### Description of Embodiments

Hereinafter, Examples of the present invention will be described with reference to the drawings. In each drawing, the same or similar constituent elements are designated by the same reference numerals and signs, and the overlapping description will be omitted.

Fig. 1 is a perspective view of a semiconductor module of Example. Fig. 2 is a cross-sectional view illustrating a state in which a circuit board is installed in the semiconductor module of Example. Fig. 3 is a cross-sectional view taken along line A-A in Fig. 1.

As shown in Fig. 1, the semiconductor module 1 of Example includes a plurality of semiconductor chips not shown, an insulating resin case 2 for accommodating the plurality of semiconductor chips in the inside thereof, and a plurality of external terminals led out to the upper surface of the insulating resin case 2. The semiconductor module 1 can be used for, for example, a power conversion device. In the present Example, an example in which an IGBT (Insulated Gate Bipolar Transistor) is used as the plurality of semiconductor chips will be described. However, not limited to this, other semiconductor chips such as a MOSFET (metal oxide semiconductor field effect transistor) may be used.

The plurality of external terminals have a pair of first potential terminals 3, a pair of second potential terminals 4 having a potential lower than that of the pair of first potential terminals 3, at least one AC terminal 5, and a plurality of auxiliary terminals 6 used for controlling a plurality of semiconductor chips accommodated inside the insulating resin case 2. Although an example having three AC terminals 5 has been shown in the present Example, the number is not limited thereto. The auxiliary terminal 6 includes, for example, a gate terminal or an emitter auxiliary terminal, but is not limited thereto, and may include a collector auxiliary terminal, or a temperature detection terminal.

Then, the upper surface of the insulating resin case 2 of the semiconductor module 1 of the present Example further has a first circuit board installation region 7 where a circuit board 20 (see Fig. 2) for controlling a plurality of semiconductor chips using a plurality of auxiliary terminals 6 can be installed, and additionally, a second circuit board installation region 8 where a circuit board protruding portion 21 of a protruding and extending portion of the circuit board 20 (see Fig. 2)can be installed.

The second circuit board installation region 8 has a shape including at least a part of a region between the pair of first potential terminals 3 and at least a part of a region between the pair of second potential terminals 4, and is a first recess 12 partitioned by a first protrusion 9 provided on the upper surface of the insulating resin case 2. As a result of this, the semiconductor module 1 having a wide region where the circuit board can be installed can be realized.

Herein, when the circuit board protruding portion 21 is installed in the second circuit board installation region 8, it is necessary to ensure a sufficient insulation distance between the circuit board protruding portion 21 and the first potential terminal 3 on the high potential side. Herein, there are two types of insulation distances: the shortest distance connected by straight lines; and the creeping distance along the surface.

Thus, in the semiconductor module 1 of the present Example, in order to ensure a creeping distance between the second circuit board installation region 8 and the first potential terminal 3, as shown in Fig. 3, it has been configured such that the upper surface of the insulating resin case 2 has a second protrusion 10 provided between each of the pair of first potential terminals 3 and the first protrusion 9, and a second recess 13 formed between the first protrusion 9 and the second protrusion 10. As a result of this, since the creeping distance is the total distance of the distances following the surfaces of the first protrusion 9, the second recess 13, and the second protrusion 10, a sufficient insulation distance can be ensured.

Incidentally, Fig. 3 shows an example in which the upper surface of the insulating resin case 2 has a third protrusion 11 provided between the first protrusion 9 and the second protrusion 10, and the second recess 13 is divided into a plurality of recesses by the third protrusion 11. As a result of this, the creeping distance can be further increased. Incidentally, the third protrusion 11 is not essential if the creeping distance is sufficient, and hence the third protrusion 11 may be omitted. In addition, it can also be configured such that a plurality of third protrusions 11 are provided to further ensure the creeping distance.

The circuit board 20 is divided into a region for controlling the semiconductor chip on the high potential side (upper arm) and a region for controlling the semiconductor chip on the low potential side (lower arm). In the present Example, the potential of the circuit board protruding portion 21 is assumed to be a region where the low potential side is controlled. Accordingly, since the potential of the circuit board protruding portion 21 of the present Example is close to that of the second potential terminal 4 on the low potential side, it is configured such that the region between the second circuit board installation region 8 and the second potential terminal 4 is only partitioned by the first protrusion 9 but no additional recess is provided. This eliminates the need for additional recesses, making it possible to enlarge the second circuit board installation region 8.

It should be noted that additional recesses may also be provided between the second circuit board installation region 8 and the second potential terminal 4 to ensure the creeping distance. In this case, for example, it may be configured such that the upper surface of the insulating resin case 2 has a fourth protrusion not shown provided between each of the pair of second potential terminals 4 and the first protrusion 9, and a third recess not shown formed between the first protrusion 9 and the fourth protrusion not shown. Further, it may also be configured such that the upper surface of the insulating resin case 2 has a fifth protrusion not shown provided between the first protrusion 9 and a fourth protrusion not shown, and the third recess not shown is divided into a plurality of recesses by the fifth protrusion not shown.

As shown in Fig. 2, the circuit board 20 has a circuit board protruding portion 21 of a protruding and extending portion of the circuit board 20. The circuit board 20 has a semiconductor chip for a drive circuit 22, which controls a plurality of semiconductor chips not shown using a plurality of auxiliary terminals 6 (see Fig. 1). The auxiliary terminal 6 also serves as a screw hole, and can establish an electrical connecting with the circuit board 20 and can perform physical fixing of the circuit board 20 by using screws 24.

Here, as shown in Fig. 1, desirably, it is configured such that the second circuit board installation region 8 has a screw hole 14 for fixing the circuit board protruding portion 21 on the upper surface of the insulating resin case 2. As a result of this, the circuit board protruding portion 21 can be fixed.

Further, as shown in Fig. 2, the circuit board 20 has a connector 23 for establishing a connection with the outside.

Further, the circuit board 20 has a magnetic flux detection part 25, such as a Hall element, at the circuit board protruding portion 21.

Fig. 4 is a diagram for illustrating a simulation result of a magnetic flux density distribution generated when a short circuit occurs in one semiconductor module in a state where two semiconductor modules of the Example are arranged in parallel.

Fig. 4 shows a magnetic flux density distribution generated when a short circuit occurs between the upper and lower arms in the right-hand semiconductor module 1 and a large current flows from the first potential terminal 3 to the second potential terminal 4, where the region shown in a bright color is a region having a high magnetic flux density and the region shown in a dark color is a region having a low magnetic flux density. As shown in Fig. 4, in the right-hand semiconductor module 1 where a short circuit has occurred, the vicinity of the center of a region surrounded by the pair of first potential terminals 3 and the pair of second potential terminals 4 has become a region having a high magnetic flux density, and by providing the second circuit board installation region 8 herein, it becomes possible to arrange the magnetic flux detection part 25 herein, so that a short circuit can be detected by the magnetic flux detection part 25 with a favorable sensitivity. In addition, the left-hand semiconductor module 1 where no short circuit occurs has become a region where the magnetic flux density in the vicinity of the second circuit board installation region 8 is small. This also provides an advantage in that it is possible to avoid false detection of a short circuit in the adjacent semiconductor module 1 by disposing the magnetic flux detection part 25 here.

As described up to this point, according to the semiconductor module 1 of Example, it is possible to achieve a semiconductor module having a wide region where a circuit board can be installed. Further, according to the semiconductor module 1 of the Example, it also becomes possible to arrange the magnetic flux detection part 25 for detecting a short circuit in the second circuit board installation region 8.

Although the Examples of the present invention have been described up to this point, the present invention is not limited to the configurations described in the Examples, and various changes are possible within the scope of the technical concept of the present invention. In addition, some or all of the configurations described in each Example may be applied in combination.

### Reference Signs List

- 1: Semiconductor module
- 2: Insulating resin case
- 3: First potential terminal
- 4: Second potential terminal
- 5: AC terminal
- 6: Auxiliary terminal
- 7: First circuit board installation region
- 8: Second circuit board installation region
- 9: First protrusion
- 10: Second protrusion
- 11: Third protrusion
- 12: First recess
- 13: Second recess
- 14: Threaded hole
- 20: Circuit board
- 21: Circuit board protruding portion
- 22: Semiconductor chip for a drive circuit
- 23: Connector
- 24: Screw
- 25: Magnetic flux detection part

## Claims

1. A semiconductor module comprising: a plurality of semiconductor chips; an insulating resin case for accommodating the plurality of semiconductor chips in an inside thereof; and a plurality of external terminals led out to an upper surface of the insulating resin case, wherein
the plurality of external terminals have a pair of first potential terminals, a pair of second potential terminals having a lower potential than that of the pair of first potential terminals, at least one AC terminal, and a plurality of auxiliary terminals used for controlling the plurality of semiconductor chips,
the upper surface of the insulating resin case has a first circuit board installation region in which a circuit board that controls the plurality of semiconductor chips using the plurality of auxiliary terminals can be installed, and a second circuit board installation region in which a circuit board protruding portion of a protruding and extending portion of the circuit board can be installed,
the second circuit board installation region is a first recess that has a shape including at least a part of a region between the pair of first potential terminals and at least a part of a region between the pair of second potential terminals and is partitioned by a first protrusion provided on the upper surface of the insulating resin case, and
the upper surface of the insulating resin case has a second protrusion provided between each of the pair of first potential terminals and the first protrusion, and a second recess formed between the first protrusion and the second protrusion.

2. The semiconductor module according to claim 1, wherein
the upper surface of the insulating resin case has a third protrusion provided between the first protrusion and the second protrusion, and
the second recess is divided into a plurality of recesses by the third protrusion.

3. The semiconductor module according to claim 1, wherein
the upper surface of the insulating resin case has a fourth protrusion provided between each of the pair of second potential terminals and the first protrusion, and a third recess formed between the first protrusion and the fourth protrusion.

4. The semiconductor module according to claim 3, wherein
the upper surface of the insulating resin case has a fifth protrusion provided between the first protrusion and the fourth protrusion, and
the third recess is divided into a plurality of recesses by the fifth protrusion.

5. The semiconductor module according to claim 1, wherein
the second circuit board installation region has a screw hole for fixing the circuit board protruding portion on the upper surface of the insulating resin case.
